# EUROPEAN PATENT SPECIFICATION

(11) **EP 0 573 534 B1**
(45) Date of publication and mention of the grant of the patent: **23.12.1998**
(21) Application number: 92906175.2
(22) Date of filing: 29.01.1992
(51) Int. Cl.: B05D 1/06, B32B 27/04, B32B 31/12

(54) **POWDER COATING METHOD FOR PRODUCING CIRCUIT BOARD LAMINAE AND THE LIKE**
PULVERBESCHICHTUNGSVERFAHREN ZUR HERSTELLUNG VON LEITERPLATTEN UND ÄHNLICHEN
PROCEDE DE DEPOT DE POUDRE POUR REVETEMENT ELECTROSTATIQUE, EN VUE DE PRODUIRE DES STRATIFIES POUR PLAQUETTES A CIRCUITS IMPRIMES ET SIMILAIRES

(30) Priority: 01.03.1991 US 663327
(43) Date of publication of application: 15.12.1993
(73) Proprietor: ELECTROSTATIC TECHNOLOGY, INC., Branford, Connecticut 06405 (US)
(72) Inventor: McKAY, Denis, R., Guilford, CT 06437 (US)
(74) Representative: Jackson, Derek Charles
(86) International application number: US9200775
(87) International publication number: WO9215404

(56) References cited:
- FR-A- 2 270 948
- GB-A- 549 615
- GB-A- 1 352 951
- JP-A-40 143 870
- US-A- 2 723 921
- US-A- 3 549 403
- US-A- 3 919 437
- US-A- 3 996 410
- US-A- 4 389 453
- US-A- 4 496 415
- "Poder breakthrough in wire coating market predicted within two years", Canadian Paint and Fishing, June 1975, pp. 24, 25, see Figures 1,2.
- MARSHALL, ADDREW, Composite Basics, 1989, pp. 1-1 to 2-1 to 2-4, see pages 1-3 and 2-3.
- KIRK-OTHMER, Encyclopedia of Chemical Technology, Vol. 6, 1979, pp. 417-418, see pg. 418.
- KIRK-OTHMER, Encyclopedia of Chemical Technology, Vol. 19, pp. 1-3, 13-19, see page 15, 17. Ed 1982.

## Description

### BACKGROUND OF THE INVENTION

Composite materials comprised of fibers in resinous matrices are taught rather extensively in the art, and are widely used for diverse applications. The reinforcing fibers contained in such composites may range in length from very short to continuous, and they may be incorporated as single strands, as multifilament bundles or yarns, and as woven or nonwoven fabrics and webs. Regardless of form, the fibers will generally be impregnated by saturating them with a dispersion, solution, or melt of the matrix-forming resin.

Circuit boards, used for printed circuit applications, are especially well suited for fabrication front composite materials of the kind described above; this use is disclosed for example in Medney et al, United States patent No. 4,943,334. Such boards are conventionally manufactured by laying up a number of plies of impregnated fiberglass cloth, and converting the resultant mass to a coherent structure through the application of heat and pressure. The impregnant will usually be either a phenolic or an epoxy thermosetting resin, and consequently the process must be carefully controlled to ensure that the thermoset material does not cure beyond its so-called "B-stage" condition; full cross-linking of the resin is reserved for subsequent laminating steps.

In common practice, the fiberglass cloth is saturated by drawing it through a solvent solution of the matrix-forming polymer. Suitable mechanical means is then used to remove excess polymer solution, and the thus-impregnated material is thereafter drawn through an oven to drive off the solvents and to flow out the resin to a "tack-free" condition; plies of the product may then be laminated to produce a multilayer circuit board structure.

The solvents for the impregnating resins used are normally toxic, and frequently they are also highly flammable; means is therefore usually required for the recycle, disposal, or destruction of the solvent after removal from the cloth. Moreover, coating processes of the kind described require constant monitoring, both to adjust the concentration of the polymer and also to control the mechanical resin-removal system.

Dry techniques for producing fiber/resin composites have been proposed in which solid particles of resin are deposited from an electrostatic fluidized bed upon strands of reinforcing filaments. As taught in the art, however, such particle-deposition methods require spreading of the fibers of a strand or bundle to permit sufficient penetration of the resin particles for adequate encapsulation; in this regard, United States patents Nos. 3,817,211 and 3,919,437, to Brown et al, are notable.

Brown et al employ electrostatic charging techniques both for strand opening and also for particle impregnation. It is taught that the invention is applicable in the production of mats, webs, or fabrics, but clearly the patents do not contemplate the impregnation of preformed fabrics, in which the constituent filaments may lie in fixed relative positions close to one another.

The following art (all patents listed being of the United States) may also be of interest to the present invention:

Hug, No. 2,706,963, discloses the electrostatic flock coating of a string while moving it through a container.

Swann, No. 2,730,455, provides a method for coating glass fibers which involves spreading of the fibers by the use of electrostatic effects.

In accordance with Harmon et al, No. 2,820,716, a nonwoven fabric is produced by electrostatically distributing dry adhesive particles throughout a loose, fibrous web, the particle subsequently being rendered adherent.

Adhesive-coated sheeting material is made, pursuant to the teachings of Dickey et al No. 2,869,511, by use of an electrostatic deposition method.

Terrell et al, No. 3,354,013, provides a process in which continuous filament tow is impregnated with a particulate additive from a fluidized bed; the prior use of induced electrostatic charges, for applying powder to fibers, is mentioned.

Williams, Jr. et al, No. 3,549,403, teaches an electrostatic deposition method for applying a powdered thermoplastic resin to uncalendered paper, followed by hot compression rolling to produce an adherent polymeric film on the paper.

Spencer, No. 3,673,027, provides a method for forming coated fibers, in which a strand of continuous filaments is bent over a guide to flatten and spread them as they enter a fluidized bed of particles.

Lamanche et al, No. 3,703,396, teaches the impregnation of strands by passing them through an electrostatic fluidized bed; separation of the fibers may be achieved by electrostatic repulsion or by air current effects, and the strands may be disposed in a parallel relationship to one another to provide a sheet of threads.

In accordance with Mayer, Jr., et al, No. 3,707,024, yarn is bulked electrostatically and is impregnated with charged resin particles.

Price, No. 3,742,106, provides a fiber-reinforced thermoplastic body by impregnating a roving in a fluidized bed, the strands of the roving being separated by a comb or by ribbed rods or bars; the use of electrostatic effects for causing penetration of the polymer is expressly discounted. In No. 4,086,872, Pan describes an electrostatic method for coating a continuous web, which web may be conductive or nonconductive.

Gray et al, No. 4,098,927, provides a method in which continuous glass roving is impregnated with resin powder in a fluidized bed, using a series of bars to separate the roving into bundles of filaments.

Garner, Nos. 4,205,515 and 4,252,583, describe an opening member that can be positioned in a fluidized bed to assist filling of cables with powder.

In accordance with Siggen et al, No. 4,338,882, a rope of fibers, spread to form a sheet, is treated with plasticizer by depositing it as a mist of electrically charged particles.

Yamada et al, No. 4,427,482, provides a method for producing prepreg rovings and fiber-reinforced plastic articles, in which polyester reactants are impregnated into the roving, which may then be consolidated with monomer-impregnated sheet plies.

Drain et al, No. 4,892,764, discloses fiber/resin composites whose resin phase is comprised of two components, at least one of which is curable by actinic radiation.

Fay et al, No. 4,913,956, teaches a moldable blanket made by depositing a liquid binder and a dry binder (the latter in the form of a powdered resin) upon glass fiber, which may contain other reinforcing fibers, as well.

Pettit, Jr., No. 4,921,913, concerns the electrostatic deposition of powder to various substrates, by use of spraying or fluidised bed apparatus; the substrates include fiber-reinforced plastics.

Asensio et al, No. 4,927,684, discloses the use of a woven fabric for reinforcing a multilayer plastic article.

In accordance with Gauchel et al, No. 4,929,651, prepregs are formed by impregnating a woven roving with a solution of a thermoset polyester, and are molded to produce ballistic resistant composites.

The above-mentioned patent to Medney et al No. 4,943,334 discloses a method for making reinforced plastic laminates for use in the production of circuit boards, in which sets of strands are maintained under a controlled tension during impregnation and cure of the resin; vacuum-assisted impregnation, using solvent-free formulations, is taught.

An electrostatic technique is disclosed in Smyser, No. Re.22,419, for coating opposite sides of fabric, paper, or the like to produce adhesive articles.

In a paper entitled "Electrostatic Prepregging of Thermoplastic Matrices," and believed to have been published in January of 1989, Muzzy et al describe the production of thermoplastic towpregs by electrostatic deposition of charged and fluidized polymer powders on spread continuous fiber tows.

United States Patent No. 4,496,415 to Sprengling describes how a dry resin powder can be used to impregnate a laminate lay up, by coating a dry resin powder directly onto a bare fibrous sheet, and then subjecting a plurality of sheets including at least one dry resin-coated sheet to an amount of heat and pressure effective to consolidate the sheets.

United States Patent No. 2,723,921 to Starkey describes the electrostatic coating of articles made of material that possess electrical insulating properties.

Notwithstanding the level of activity in the art evidenced by the foregoing, the need remains for a practical and commercially attractive method for the production of a composite web, comprised of a fabric of multi-filament bundles in a matrix of synthetic resinous material, wherein the filaments are maintained in substantially fixed relative positions of close mutual contact during coating and impregnation of the fabric. Accordingly, it is an object of the present invention to provide a method to satisfy the need described.

### SUMMARY OF THE DISCLOSURE

According to the present invention there is provided a method for the production of a composite web, comprising the steps:
providing a continuous-length fabric composed of multi-filament bundles, the filaments of said bundles being in substantially fixed relative positions of close mutual contact;
transporting said fabric sequentially through a wetting station, a coating station, and a heating station, without substantial opening of said bundle filaments;
coating said fabric at said coating station by depositing thereupon solid particles of a fusible synthetic resinous material; and
heating said coated fabric at said heating station to an elevated temperature above ambient, said elevated temperature being sufficiently high, and being maintained for a sufficient period, to effect fusion of said resinous material and movement thereof into said bundles, thereby to effect encapsulation of said filaments by said resinous material, said resinous material remaining fusible at said elevated temperature,
   wherein moisture, selected from the group consisting of liquid water and steam, is applied to said fabric at said wetting station.

The method may be effected in the absence of applied pressure.

The average particle size of said synthetic resinous material may be substantially larger than the diameter of said filaments. For example, the average particle size of said resinous material may be 20 to 100 microns, while the diameter of said filaments may be 6 to 10 microns.

The fabric may be woven, the weave of said fabric being sufficiently tight as to substantially immobilize said filaments of said bundles against displacement from said fixed relative positions thereof.

The filaments may be selected from the group consisting of cellulosic fibers, fiberglass, carbon fibers, graphite fibers, polyester fibers, aramids, and mixtures thereof.

The fabric may exit said wetting station with a moisture content substantially below saturation.

Both faces of said fabric may be coated at said coating station by electrostatically depositing thereupon solid particles of a fusible synthetic resinous material. For example, said fabric may be transported vertically through said coating station, said coating station effectively providing an electrostatic fluidized bed of particulate material on both of the two opposite sides of said fabric to effect coating thereof.

The build of said resinous material on said fabric may be sufficient to cause substantially complete encapsulation of said filaments through the full thickness of said web.

The method may include the additional step of cooling said coated fabric to solidify said fused resinous material.

The synthetic resinous material may be a thermosetting resin, said elevated temperature of said heating step being sufficient to convert said resin to its B-stage condition only.

The invention also relates to a composite web made by the above-defined method.

The method may include the further step of forming said composite web under heat and pressure to produce an article of manufacture. In this case, a plurality of pieces of said composite web may be stacked and then subjected to said further step, to produce a laminate structure. The temperature attained in said forming step may be higher than said elevated temperature and sufficient to convert said resinous material to its fully cured, thermoset condition. The invention also relates to a laminate structure suitable for use in a circuit board and made by the defined method.

The method according to the invention permits production to be carried out at high rates of speed, for example at line speeds of 18 meters per minute, and substantially higher, and on readily available equipment, and in which full impregnation of the resin into the fibrous component is achieved effectively, with facility, and at atmospheric pressure to produce a composite web that is free from voids and residual solvent occlusions. Any of numerous species of fibrous materials and resinous materials can be readily combined with one another. The method is also highly advantageous from economic as well as environmental standpoints.

### DESCRIPTION OF THE DRAWING

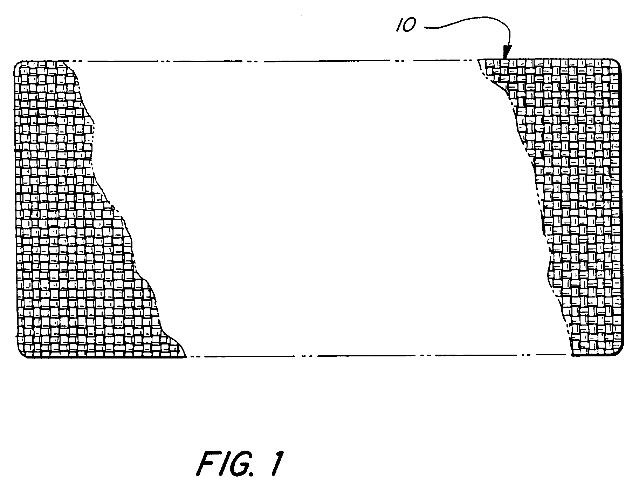

Figure 1 is a plan view of a section, generally designated by the numeral 10, of a composite web embodying the invention, in which the fibers of a plain weave fabric are encapsulated within a matrix of synthetic resinous material.

### DETAILED DESCRIPTION OF THE INVENTION AND PREFERRED EMBODIMENTS

In carrying out the instant method, moisture is applied to the fabric at the wetting station to enhance electrical conductivity, and thereby afford practical deposition rates. The fabric will preferably exit from the wetting station with a moisture content substantially below saturation, as may result by merely spraying its surfaces with water. In any case, it will be important to minimize drag-out and carryover of water to the electrostatic coating unit, and that may best be accomplished by using steam, rather than liquid water, to effect moisturization.

At the coating station, solid particles of a fusible synthetic resinous material are electrostatically deposited upon the substrate (preferably on both faces), and at the heating station the fabric is heated to an elevated temperature above ambient using any appropriate source of thermal energy, including radiant and/or convection heating. The coated substrate is maintained at temperature for a period sufficient to effect fusion of the resinous material and movement thereof into the bundles, thereby to achieve encapsulation of the filaments; the resin is believed to infuse into the fibrous material through capillary action, displacing any air or moisture that may be present in the interstices. Needless to say, the oven, bank of lamps, or other form of heating station employed must be of a sufficient length to enable both effects to occur before the resin loses its requisite fluidity, and therefore it is the heating station that will usually represent the limiting factor in attaining maximum throughput rates.

It will also be appreciated that the resinous material must remain fusible at the elevated temperature to which the substrate is initially heated. Thermoplastic resins will of course inherently remain reversely fusible; to maintain thermosetting resins in that state, however, care must be taken not to prematurely heat the resin to a temperature above that at which it will exist in its B-stage (cross-linked, but less than fully cured) condition. The resin must exhibit a melt viscosity at the temperature of operation which is sufficiently low to permit a degree of penetration that is adequate to achieve the objectives set forth.

Although it is believed that any conventional fabric style or weave known to those skilled in the art (e.g. basket, plain, crowfoot satin, harness satin) can be utilized in the practice of the present invention, greatest benefit will often be realized when the fabric has a weave that is sufficiently tight as to substantially immobilize the filaments of the constituent bundles against relative displacement from their established positions of intimate mutual contact. The filaments of which the fibrous substrate is comprised will advantageously be selected from the group consisting of cellulosic fibers, fiberglass, carbon fibers, graphite fibers, polyester fibers, aramids (e.g., Kevlar) and mixtures thereof. By way of example, the filament diameter will desirably be in the range 6 to 10 microns, and the denier of the warp and filling yarns (e.g. , of a Kevlar fabric) will typically have a value in the range 195 to 3000; the yarn count (warp x filling, per inch) will typically be in the range 17x17 to 50x50, and the fabric will desirably be about 0,127 mm - 0,762 mm (5 to 30 mils) thick.

Although horizontal coating may be employed, in the preferred embodiments the substrate will be transported vertically through a coating station which effectively provides an electrostatic fluidized bed of particulate material on both of its sides; that is to say, either two coating units may be used, or a single piece of apparatus may provide separate fluidized bed effects on the opposite sides of a web. Suitable electrostatic fluidized bed powder coating apparatus is disclosed, inter alia, in United States patents Nos. 3,828,729, to Goodridge; 3,916,826, to Knudsen; 4,030,446, to Karr; 4,297,386 and 4,330,567, to Gillette; 4,332,835, to Knudsen; 4,418,642 and 4,472,452, to Gillette et al; and 4,517,219, to Hajek, and is commercially available from the common assignee of those patents and of the instant application, S.L. Electrostatic Technology, Inc., of Branford, Connecticut. As compared to powder spray guns, electrostatic fluidized beds will usually be deemed preferable, largely because of the uniformity of particulate material deposition of which they are capable.

The synthetic resinous material used for coating may, as noted, be either a thermosetting resin or a thermoplastic resin; suitable classes of resins include epoxy resins, phenolic resins, polyester resins, polyether resins, alkyd resins, polyamide resins, polyimide resins, bismaleimide resins, polyolefins, vinyl resins, etc., as will be evident to those skilled in the art. The resin particles will normally be of a size in the range 10 to 200 microns, and preferably 20 to 100 microns; fluidization of powders finer than 10 microns and coarser than 200 microns is problematic. It should be noted that the ability to effectively encapsulate fine filaments (e.g., of 6 to 10 microns diameter) using a resin of substantially larger average particle size (e.g., of 20 to 100 microns) is regarded to be a surprising benefit of the instant method. The build on the substrate will advantageously be sufficient to cause substantially complete encapsulation of the filaments throughout the full thickness of the fabric; normally, sufficient resin will be deposited to provide about 35 to 70 percent thereof, based upon the weight of the composite web.

The method of the invention will usually include the additional step of cooling the composite to solidify the fused resinous material, and in most instances it will advantageously include the further step of forming the resultant web, under heat and pressure, to produce an article of manufacture. More particularly, a plurality of plies of a fabric-reinforced composite web may be stacked and then subjected to the forming step, to produce a laminate structure suitable for use in the manufacture of circuit boards. It will be appreciated that, when a thermosetting matrix resin is employed, the temperature attained in the forming step will be higher than that at which fusion is effected in the initial heating step, and will be sufficient to convert the resinous material to its fully cured condition. Thermosetting resins used must of course have a glass transition temperature that is low enough to permit flow-out at the temperature of initial heating, without effecting excessive crosslinking.

### EXAMPLE ONE

As a specific example, a double-effect (i.e., two-sided) electrostatic fluidized bed and an infrared oven about 10 meters in length are used to coat a fabric conveyed vertically therethrough, so as to produce an "FR-4" type of circuit board. The fabric is woven fiberglass cloth, 0,127 mm (5 mils) thick and comprised of bundles of about 60 filaments each, and the impregnating resin is a brominated epoxy containing an accelerator and catalyst (commercially available from Dow Chemicals, under the trade designation DER 521-80), having a gel time of about 250 seconds and a weight average particle size of 60 microns. Water sprays are used to wet the opposite surfaces of the web (without saturating it) prior to coating. Operating under atmospheric pressure and at a powder charging potential of 64 KV the fabric is electrostatically coated on both sides; it is heated to about 285° Centigrade. A resin content of about 55 weight percent is readily produced in the fabric at a throughput rate in excess of 10 meters per minute, and the gel time of the cooled resin is about 150 second. Microphotographs of the composite, taken along a cross-sectional cut line, shows the filaments of the fabric to be fully encapsulated by the epoxy resin, and the matrix to be virtually free from voids.

Apart from the unique ability of the instant method to effect coating of fibrous substrates made from yarns in which the filaments are maintained in close mutual contact, one of its primary benefits resides in the avoidance of solvents. Not only does this eliminate the hazards, expense, and time constraints associated with the need to drive off and subsequently deal with such substances, but it also facilitates the production of products that are free from voids and it ensures the absence of trapped solvent bubbles, the elimination of which will generally be found to be prohibitively expensive, if possible at all; such defects are of course particularly undesirable (or indeed intolerable) in electrical devices such as PCBs. The absence of solvents from the present process also contributes to its utility for making thick laminates comprised of relatively few plies, each of which plies can be thicker than might otherwise be the case, thus further enhancing the economy of manufacture. The inherent tack-free nature of the composite webs (at room temperature) facilitates their subsequent processing, and the option of using thermoplastic resins can afford enhanced thermal properties in the products, virtually infinite self-life and the ability to form shaped circuit boards.

Thus, it can be seen that the present invention provides a practical and commercially attractive method for the fabrication of fiber-reinforced composite materials, using fabrics composed of multifilament bundles. Production can be carried out at high rates of speed, at ambient pressures and on commercially available equipment; there is no need for electrostatically charging the filaments to promote their separation (or indeed for electrical grounding of the substrate). Full impregnation of the resin into the fibrous component is readily and effectively achieved, and the method is highly advantageous from both economic and also environmental standpoints. Numerous combinations of fibers and resins can be used in the practice of the method, which is especially well suited for the production of laminae adapted for use as circuit board substrates, as well as for the manufacture of the circuit board structures themselves.

## Claims

1. A method for the production of a composite web, comprising the steps:
providing a continuous-length fabric composed of multi-filament bundles, the filaments of said bundles being in substantially fixed relative positions of close mutual contact;
transporting said fabric sequentially through a wetting station, a coating station, and a heating station, without substantial opening of said bundle filaments;
coating said fabric at said coating station by depositing thereupon solid particles of a fusible synthetic resinous material; and
heating said coated fabric at said heating station to an elevated temperature above ambient, said elevated temperature being sufficiently high, and being maintained for a sufficient period, to effect fusion of said resinous material and movement thereof into said bundles, thereby to effect encapsulation of said filaments by said resinous material, said resinous material remaining fusible at said elevated temperature,
characterised in that moisture, selected from the group consisting of liquid water and steam, is applied to said fabric at said wetting station.

2. The method of claim 1, characterised in that said method is effected in the absence of applied pressure.

3. The method of claim 1 or claim 2, characterised in that the average particle size of said synthetic resinous material is substantially larger than the diameter of said filaments.

4. The method of claim 3, characterised in that the average particle size of said resinous material is 20 to 100 microns, and in that the diameter of said filaments is 6 to 10 microns.

5. The method of any preceding claim, characterised in that said fabric is woven, and in that the weave of said fabric is sufficiently tight as to substantially immobilize said filaments of said bundles against displacement from said fixed relative positions thereof.

6. The method of any preceding claim, characterised in that said filaments are selected from the group consisting of cellulosic fibers, fiberglass, carbon fibers, graphite fibers, polyester fibers, aramids, and mixtures thereof.

7. The method of any preceding claim, characterised in that said fabric exits said wetting station with a moisture content substantially below saturation.

8. The method of any preceding claim, characterised in that both faces of said fabric are coated at said coating station by electrostatically depositing thereupon solid particles of a fusible synthetic resinous material.

9. The method of claim 8, characterised in that said fabric is transported vertically through said coating station, and in that said coating station effectively provides an electrostatic fluidized bed of particulate material on both of the two opposite sides of said fabric to effect coating thereof.

10. The method of any preceding claim, characterised in that the build of said resinous material on said fabric is sufficient to cause substantially complete encapsulation of said filaments through the full thickness of said web.

11. The method of any preceding claim, characterised by the additional step of cooling said coated fabric to solidify said fused resinous material.

12. The method of any preceding claim, characterised in that said synthetic resinous material is a thermosetting resin, and in that said elevated temperature of said heating step is sufficient to convert said resin to its B-stage condition only.

13. The method of any preceding claim, characterised by the further step of forming said composite web under heat and pressure to produce an article of manufacture.

14. The method of claim 13, characterised in that a plurality of pieces of said composite web are stacked and then subjected to said further step, to produce a laminate structure.

15. The method of claim 13 or 14, when dependent on claim 12, characterised in that the temperature attained in said forming step is higher than said elevated temperature and sufficient to convert said resinous material to its fully cured, thermoset condition.

16. A composite web made by the method of any one of claims 1 to 12.

17. A laminate structure suitable for use in a circuit board and made by the method of any one of claims 13 to 15.

## Patentansprüche

1. Verfahren zur Herstellung einer Verbundstoffbahn, umfassend die folgenden Schritte:
Bereitstellen eines endlosen Gewebes aus Multifilamentbündeln, wobei sich die Filamente der genannten Bündel an im wesentlichen festen relativen Positionen in engem gegenseitigem Kontakt befinden;
Transportieren des genannten Gewebes nacheinander durch eine Benetzungsstation, eine Beschichtungsstation und eine Erhitzungsstation ohne erhebliche Öffnung der genannten Bündelfilamente;
Beschichten des genannten Gewebes in der genannten Beschichtungsstation durch Auftragen von Feststoffpartikeln eines schmelzbaren synthetischen Harzmaterials darauf; und
Erhitzen des genannten beschichteten Gewebes in der genannten Erhitzungsstation auf eine über der Umgebungstemperatur liegende erhöhte Temperatur, wobei die genannte erhöhte Temperatur hoch genug ist und für einen ausreichenden Zeitraum gehalten wird, um ein Schmelzen des genannten Harzmaterials und dessen Übergang in die genannten Bündel und dadurch eine Einkapselung der genannten Filamente durch das genannte Harzmaterial zu bewirken, wobei das genannte Harzmaterial bei der genannten erhöhten Temperatur schmelzfähig bleibt,
dadurch gekennzeichnet, daß Feuchtigkeit, ausgewählt aus der Gruppe bestehend aus flüssigem Wasser und Dampf, in der genannten Benetzungsstation auf das genannte Gewebe aufgebracht wird.

2. Verfahren nach Anspruch 1, dadurch gekennzeichnet, daß das Verfahren ohne Druckbeaufschlagung durchgeführt wird.

3. Verfahren nach Anspruch 1 oder Anspruch 2, dadurch gekennzeichnet, daß die durchschnittliche partikelgröße des genannten synthetischen Harzmaterials erheblich höher ist als der Durchmesser der genannten Filamente.

4. Verfahren nach Anspruch 3, dadurch gekennzeichnet, daß die durchschnittliche Partikelgröße des genannten Harzmaterials zwischen 20 und 100 Mikron liegt, und dadurch, daß der Durchmesser der genannten Filamente zwischen 6 und 10 Mikron beträgt.

5. Verfahren nach einem der vorherigen Ansprüche, dadurch gekennzeichnet, daß das genannte Gewebe gewebt ist, und dadurch, daß die Bindung des genannten Gewebes ausreichend fest ist, um die genannten Filamente der genannten Bündel gegen eine Verschiebung von deren genannten festen relativen Positionen im wesentlichen zu immobilisieren.

6. Verfahren nach einem der vorherigen Ansprüche, dadurch gekennzeichnet, daß die Filamente ausgewählt werden aus der Gruppe bestehend aus Zellulosefasern, Glasfasern, Kohlenstoffasern, Graphitfasern, Polyesterfasern, Aramiden und Gemischen davon.

7. Verfahren nach einem der vorherigen Ansprüche, dadurch gekennzeichnet, daß das genannte Gewebe die genannte Benetzungsstation mit einem Feuchtigkeitsgehalt verläßt, der erheblich unter dem Sättigungsgrad liegt.

8. Verfahren nach einem der vorherigen Ansprüche, dadurch gekennzeichnet, daß beide Seiten des genannten Gewebes in der genannten Beschichtungsstation durch elektrostatisches Auftragen von Feststoffpartikeln eines schmelzbaren synthetischen Harzmaterials darauf beschichtet werden.

9. Verfahren nach Anspruch 8, dadurch gekennzeichnet, daß das genannte Gewebe senkrecht durch die genannte Beschichtungsstation transportiert wird, und dadurch, daß die genannte Beschichtungsstation effektiv eine elektrostatische Wirbelschicht aus partikulärem Material auf den beiden gegenüberliegenden Seiten des genannten Gewebes bildet, um dessen Beschichtung zu bewirken.

10. Verfahren nach einem der vorherigen Ansprüche, dadurch gekennzeichnet, daß der Aufbau des genannten Harzmaterials auf dem genannten Gewebe ausreicht, um eine im wesentlichen vollständige Einkapselung der genannten Filamente durch die volle Dicke der genannten Bahn zu bewirken.

11. Verfahren nach einem der vorherigen Ansprüche, gekennzeichnet durch den zusätzlichen Schritt des Kühlens des genannten beschichteten Gewebes, um das genannte geschmolzene Harzmaterial zu verfestigen.

12. Verfahren nach einem der vorherigen Ansprüche, dadurch gekennzeichnet, daß das genannte synthetische Harzmaterial ein härtbares Harz ist, und dadurch, daß die genannte erhöhte Temperatur des genannten Erhitzungsschrittes ausreicht, um das genannte Harz nur in seinen B-Zustand zu versetzen.

13. Verfahren nach einem der vorherigen Ansprüche, gekennzeichnet durch den weiteren Schritt des Formens der genannten Verbundstoffbahn unter Wärme und Druck zu einem Herstellungsartikel.

14. Verfahren nach Anspruch 13, dadurch gekennzeichnet, daß eine Mehrzahl von Stücken der genannten Verbundstoffbahn gestapelt und dann dem genannten weiteren Schritt unterzogen wird, um eine Laminatstruktur zu erzeugen.

15. Verfahren nach Anspruch 13 oder 14 in Abhängigkeit von Anspruch 12, dadurch gekennzeichnet, daß die in dem genannten Formschritt erzielte Temperatur höher ist als die genannte erhöhte Temperatur und ausreicht, um das genannte Harzmaterial in seinen vollständig erhärteten duroplastischen Zustand zu versetzen.

16. verbundstoffbahn, hergestellt mit dem Verfahren nach einem der Ansprüche 1 bis 12.

17. Laminatstruktur, geeignet für die Verwendung in einer Leiterplatte und hergestellt nach dem Verfahren nach einem der Ansprüche 13 bis 15.

## Revendications

1. Une méthode pour la production d'une bande en composite, comportant les étapes suivantes :
production d'un tissu en longueur continue, composé de faisceaux multifilaments, les filaments des dits faisceaux étant dans des positions relatives substantiellement fixes de contact mutuel étroit ;
transport dudit tissu séquentiellement à travers une station de mouillage, une station d'enduction et une station de chauffage, sans ouverture importante des dits filaments de faisceaux ;
enduction dudit tissu dans ladite station d'enduction par déposition, sur le tissu, de particules solides d'une matière résineuse synthétique fusible ; et
chauffage dudit tissu enduit dans ladite station de chauffage à une température élevée au-dessus de la température ambiante, ladite température élevée étant suffisamment forte et étant maintenue pendant une période suffisamment longue pour réaliser la fusion de ladite matière résineuse et son mouvement à l'intérieur des dits faisceaux, de manière à effectuer l'encapsulation des dits filaments par ladite matière résineuse, ladite matière résineuse demeurant fusible à ladite température élevée,
caractérisée en ce que de l'humidité, sélectionnée à partir du groupe comportant l'eau en phase liquide et la vapeur, est appliquée au dit tissu dans ladite station de mouillage.

2. La méthode de la revendication 1, caractérisée en ce que ladite méthode est réalisée en l'absence d'une application de pression.

3. La méthode de la revendication 1 ou 2, caractérisée en ce que la granulométrie moyenne de ladite matière résineuse synthétique est considérablement plus grande que le diamètre des dits filaments.

4. La méthode de la revendication 3, caractérisée en ce que la granulométrie moyenne de ladite matière résineuse est comprise entre 20 et 100 microns, et en ce que le diamètre des dits filaments est compris entre 6 et 10 microns.

5. La méthode selon l'une quelconque des revendications précédentes, caractérisée en ce que ledit tissu est tissé, et en ce que le tissage dudit tissu est suffisamment serré pour immobiliser substantiellement les dits filaments des dits faisceaux contre tout déplacement à partir de leurs positions relatives fixes.

6. La méthode selon l'une quelconque des revendications précédentes, caractérisée en ce que les dits filaments sont sélectionnés à partir du groupe comportant les fibres de cellulose, la fibre de verre, les fibres de carbone, les fibres de graphique, les fibres de polyester, les aramides et des mélanges de ces fibres.

7. La méthode selon l'une quelconque des revendications précédentes, caractérisée en ce que ledit tissu sort de ladite station de mouillage avec une teneur en humidité considérablement inférieure à la saturation.

8. La méthode selon l'une quelconque des revendications précédentes, caractérisée en ce que les deux faces du tissu sont enduites dans ladite station d'enduction par déposition électrostatique sur ses faces de particules solides d'une matière résineuse synthétique fusible.

9. La méthode de la revendication 8, caractérisée en ce que ledit tissu est transporté verticalement à travers ladite station d'enduction, et en ce que ladite station d'enduction fournit effectivement un lit fluidisé électrostatique de matière particulaire sur les deux faces opposées dudit tissu pour en réaliser l'enduction.

10. La méthode selon l'une quelconque des revendications précédentes, caractérisée en ce que l'accumulation en épaisseur de ladite matière résineuse sur ledit tissu est suffisante pour causer une encapsulation substantiellement complète des dits filaments, sur toute l'épaisseur de ladite bande.

11. La méthode selon l'une quelconque des revendications précédentes, caractérisée par l'étape additionnelle de refroidissement dudit tissu enduit pour solidifier ladite matière résineuse fondue.

12. La méthode selon l'une quelconque des revendications précédentes, caractérisée en ce qui ladite matière résineuse synthétique est une résine thermodurcissable et en ce que ladite température élevée de ladite étape de chauffage est suffisante pour convertir ladite résine en son état "B" uniquement.

13. La méthode selon l'une quelconque des revendications précédentes, caractérisée par l'étape additionnelle de formation de ladite bande en composite, sous chaleur et pression, pour produire un article fabriqué.

14. La méthode selon la revendication 13, caractérisée en ce qu'une pluralité de morceaux de ladite bande en composite sont empilés puis soumis à ladite étape additionnelle, pour produire une structure stratifiée.

15. La méthode selon la revendication 13 ou 14, lorsque annexée à la revendication 12, caractérisée en ce que la température atteinte pendant ladite étape de formation excède ladite température élevée et est suffisante pour convertir ladite matière résineuse en son état thermodurci, entièrement traité.

16. Une bande en composite réalisée par la méthode de l'une quelconque des revendications 1 à 12.

17. Une structure stratifiée convenant à l'utilisation dans une carte ou plaquette de circuits imprimées et réalisée selon la méthode de l'une quelconque des revendications 13 à 15.
